Europäisches Patentamt

European Patent Office

Office européen des brevets

(19)

(11) Numéro de publication: **0 133 396**
**B1**

(12) **FASCICULE DE BREVET EUROPÉEN**

(45) Date de publication du fascicule du brevet:
13.01.88

(51) Int. Cl.⁴: **H 05 K 3/30,** H 05 K 7/12

(21) Numéro de dépôt: **84401530.5**

(22) Date de dépôt: **20.07.84**

(54) **Support de voyant lumineux sur circuit imprimé.**

(30) Priorité: **01.08.83 FR 8312627**

(43) Date de publication de la demande:
**20.02.85 Bulletin 85/8**

(45) Mention de la délivrance du brevet:
**13.01.88 Bulletin 88/2**

(84) Etats contractants désignés:
**BE DE GB IT NL SE**

(56) Documents cité:
**CH-A-620 315**
**DE-A-2 714 168**
**DE-A-2 718 442**
**US-A-4 065 198**
**US-A-4 219 172**

(73) Titulaire: **LA TELEMECANIQUE ELECTRIQUE, 33
bis, avenue du Maréchal Joffre, F-92000 Nanterre
(FR)**

(72) Inventeur: **Lerude, Gérard, Chemin du Puy Parc
Maré- Polis Résidence la Vigie, F-06600 Antibes
(FR)**
Inventeur: **Roux, Christine, Quartier le Collet Opio,
F-06650 Le Rouret (FR)**

(74) Mandataire: **Marquer, Francis, CABINET
MOUTARD 35, avenue Victor Hugo Résidence
Champfleury, F-78180 Voisins- le- Bretonneux (FR)**

EP 0 133 396 B1

## Description

L'invention se rapporte aux dispositifs servant à supporter un voyant lumineux, tel que diode électroluminescente et à le positionner et le fixer à une carte de circuit imprimé.

Parmi les dispositifs connus, certains assurent un positionnement et une fixation efficaces et stables, mais requièrent des opérations de montage des voyants relativement compliquées et onéreuses; d'autres sont plus simples à mettre en oeuvre, mais n'assurent pas un positionnement très précis, cette dernière qualité étant peu compatible avec le fait que, pendant le montage, certains jeux doivent être tolérés si l'on veut atteindre une cadence de production élevée. Dans tous ces dispositifs, les fils de connexion doivent être cambrés sur un montage approprié avant leur insertion dans des trous du circuit imprimé.

L'état de la technique est illustré par DE-Al-2 714 168, qui décrit un support de voyant lumineux comportant un corps isolant allongé ayant une face avant et une face arrière sensiblement perpendiculaires à sa dimension longitudinale et formant, au niveau de sa face avant, des mâchoires destinées à l'insertion du voyant, une surface d'appui à l'intérieur dudit corps coopérant avec la surface arrière du voyant, des trous de passage des fils de celui-ci ménagés à travers ledit corps et des moyens de fixation à une carte de circuit imprimé ayant des trous de raccordement des fils, ledit corps formant une surface de référence perpendiculaire à la face arrière et raccordée à celle-ci par une surface rentrante agencée pour dégager une portion desdits fils. L'invention se propose de réaliser un dispositif simple dans lequel l'opération prédéterminée de cambrage, plus particulièrement des fils, est supprimée.

Suivant l'invention, ce résultat est obtenu au moyen d'un support de voyant lumineux tel que défini ci-dessus selon DE-Al-2 714 168 comportant un corps isolant, caractérisé en ce que ladite surface arrière est conformée pour que le rabattement dudit corps d'une première position où sa face arrière est en appui sur la carte et joue le rôle d'entretoise définissant une distance prédéterminée entre la surface arrière du voyant et la surface du circuit imprimé en vue de la soudure des fils non cambrés introduits dans les trous de raccordement, à une seconde position où ladite surface de référence est en appui sur la carte, ait pour effet de provoquer un cambrage prédéterminé desdits fils.

Dans un mode d'exécution préféré, lesdits moyens de fixation comprennent un crochet agencé pour coopérer, par encliquetage, avec le bord du circuit imprimé voisin des trous de passage des fils, lorsque ledit corps est en position rabattue.

Selon une particularité additionnelle, ladite surface rentrante est conformée pour servir de gabarit de cambrage aux fils, de telle sorte, qu'après encliquetage, une contrainte élastique résiduelle continue d'être exercée sur lesdits fils.

D'autres particularités, ainsi que les avantages de l'invention, apparaîtront clairement à la lumière de la description ci-après.

Au dessin annexé:

La figure 1 est une vue de l'avant d'un dispositif conforme à un mode d'exécution préféré de l'invention;

La figure 2 est une vue de l'arrière du dispositif;

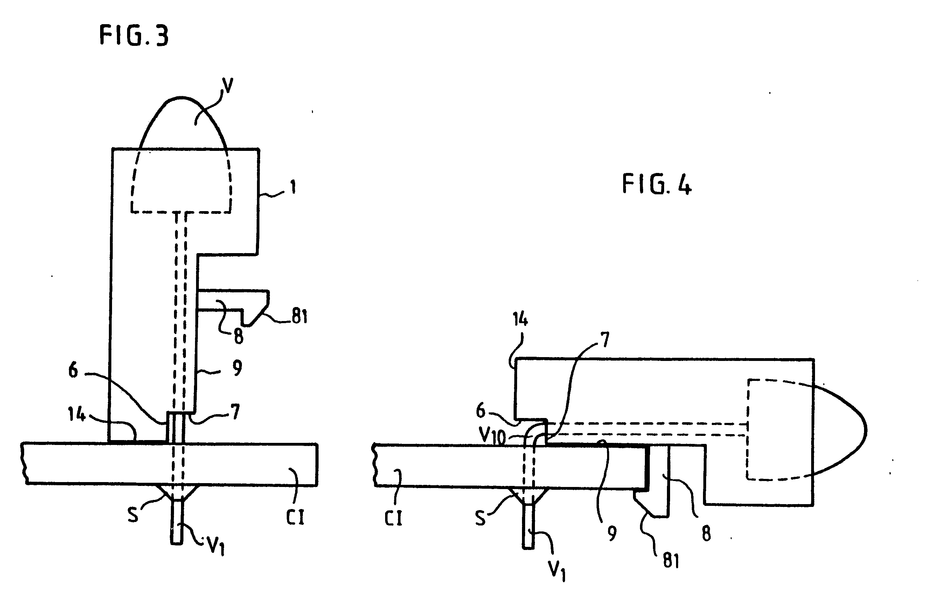

La figure 3 est une vue de profil du dispositif, dans une première phase de son montage sur un circuit imprimé;

La figure 4 représente le dispositif dans la phase inale du montage; et

La figure 5 représente une bande de plusieurs dispositifs identiques détachables.

Les mêmes numéros de référence désignent les mêmes éléments aux différentes figures.

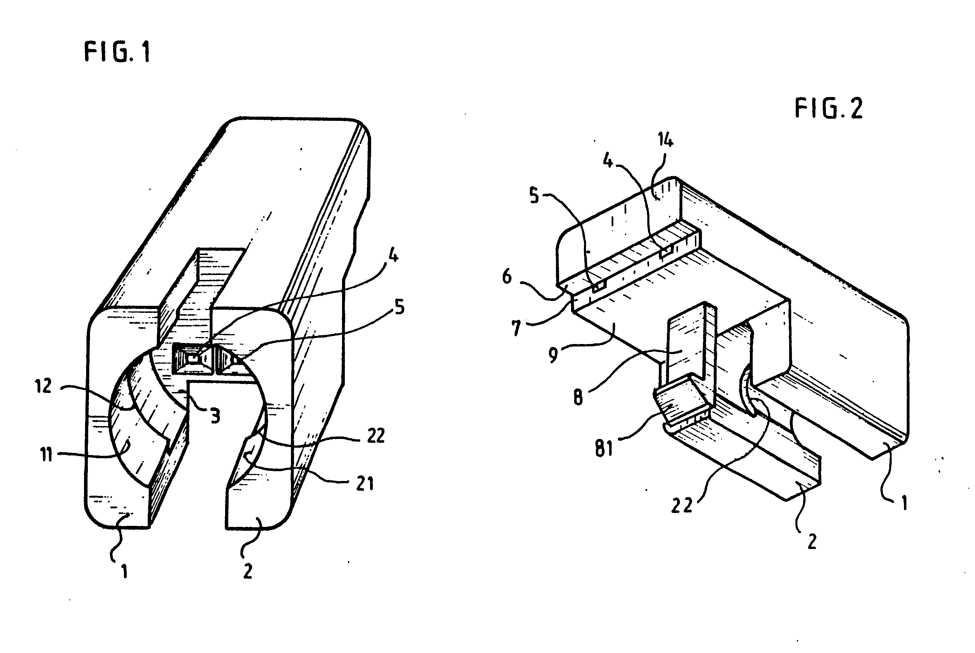

A la figure 1, on voit que le logement du voyant (non figuré) est délimité par deux mâchoires souples 1, 2 et une surface d'appui 3 comportant deux trous 4 et 5 avec chanfrein facilitant l'introduction des fils du voyant. Les mâchoires 1 et 2 comportent, sur leur face interne, des chanfreins 11 et 21, délimités vers le fond par des arêtes 12 et 22 qui freinent le voyant pour en empêcher l'extraction pendant les phases intermédiaires de montage.

A la figure 2, on voit que les passages de fils 4 et 5 débouchent au niveau d'une surface rentrante 6, 7 conformée, dans l'exemple non limitatif décrit, en gradin dont la hauteur 6 est supérieure à la largeur 7. Une surface 9, perpendiculaire aux faces avant 1, 2 et arrière 14, sert d'appui sur le circuit imprimé sur lequel le voyant est monté et un crochet 8 muni d'un chanfrein 81 destiné à faciliter son encliquetage sur le bord du circuit imprimé, est disposé perpendiculairement à la surface 9. Après avoir inséré un voyant V à corps cylindrique ou en forme d'ogive entre les mâchoires 1 et 2, on introduit les fils V1, V2 dans les trous de raccordement d'un circuit imprimé CI. Le corps du dispositif sert d'entretoise pour limiter la pénétration des fils à la cote voulue en prenant appui sur le circuit imprimé par sa face arrière 14. On relie ensuite les fils électriquement et mécaniquement au circuit imprimé par des soudures S. Ces soudures sont réalisables par passage à la vague comme pour de simples résistances. Après soudure des fils, on rabat l'ensemble constitué par le voyant et son support vers le rebord du circuit imprimé, ce qui plie les fils au niveau V10 et permet, en fin de mouvement, d'encliqueter le crochet 8, grâce à son chanfrein 81, au bord du circuit CI et de plaquer ainsi la face 9 du support sur la surface du circuit imprimé. La hauteur 6 du gradin délimite la longueur de la zone de flexion V10 des fils et la distance qui sépare leur sortie de la face 9 le long de la face 7 définit leur rayon de cambrage. Le gradin sert ainsi de gabarit de cambrage des fils, gabarit qui sera avantageusement déterminé pour laisser subsister une certaine contrainte élastique sur les fils après encliquetage. L'encliquetage du crochet 8 sur le rebord du circuit imprimé exerce alors une contrainte de flexion sur la zone V10 des fils, dont l'élasticité produit un effort de rappel qui plaque le crochet sur le rebord du circuit imprimé.

La position finale du dispositif est définie sans jeux résiduels. En effet, la surface de référence 9 se trouve, après encliquetage, plaquée contre le circuit imprimé, et le crochet 8, relativement large, est plaqué contre le bord dudit circuit imprimé par l'élasticité de la sone V10 des fils, ce qui garantit la bonne orientation du support et du voyant qui en est solidaire.

Le dispositif que l'on vient de décrire, constitué en une seule pièce isolante, cumule les fonctions suivantes:

- protection mécanique du voyant;
- entretoise de positionnement du voyant, fils non cambrés, permettant de souder à la vague l'ensemble constitué par le support et le voyant comme une simple résistance;
- gabarit de cambrage des fils après soudure;
- support de voyant s'encliquetant en éliminant les jeux, en fin de cambrage, sur le bord du circuit imprimé;
- maintien mécanique efficace de la position et de l'orientation du voyant.

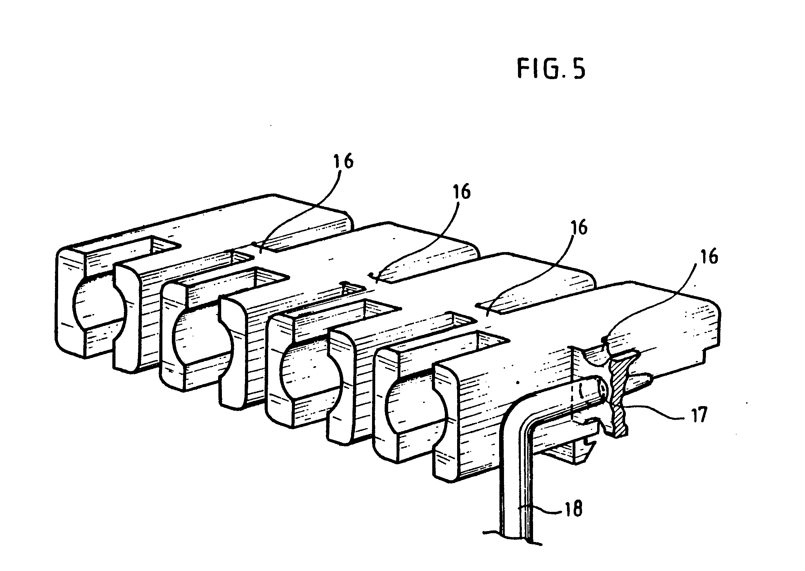

Comme le montre la figure 5, le dispositif est réalisable en bande de plusieurs éléments identiques reliés entre eux par des parties affaiblies 16 et détachables, utilisables individuellement ou par barrettes supportant plusieurs voyants à intervalles prédéterminés.

Pour faciliter l'introduction des fils des différents voyants à monter sur une même barrette de support, il est avantageux d'insérer d'abord un voyant à chaque extrémité de la barrette, d'enfiler alors les fils correspondants dans les trous voulus du circuit imprimé, ce qui aligne la barrette sur le circuit et d'enfiler chacun des autres voyants simultanément au travers de la barrette et du circuit imprimé. Cette fonction de guide-fil, au moment de l'insertion, peut faire gagner beaucoup de temps par rapport au montage d'un dispositif connu du genre plastron portant des voyants dont les fils sont précambrés.

Le mode opératoire décrit ci-dessus est applicable sur machine d'insertion automatique des voyants, par exemple en utilisant deux positions inoccupées pour placer des picots de centrage flexibles. Une autre solution, illustrée à la figure 5, consiste à positionner la barrette de support à l'aide d'un outil spécifique 18 muni de deux pointes pénétrant dans deux trous 17 ménagés dans deux des parties affaiblies 16 de la barrette, pour la maintenir sur le circuit pendant l'insertion automatique des voyants au travers des trous 4 et 5 et des trous correspondants du circuit imprimé.

**Revendications**

1. Support de voyant lumineux comportant un corps isolant allongé ayant une face avant et une face arrière sensiblement perpendiculaires à sa dimension longitudinale et formant, au niveau de sa face avant, des mâchoires destinées à l'insertion du voyant, une surface d'appui à l'intérieur dudit corps coopérant avec la surface arrière du voyant, des trous de passage des fils de celui-ci ménagés à travers ledit corps et des moyens de fixation à une carte de circuit imprimé, ayant des trous de raccordement des fils, ledit corps formant une surface de référence (9) perpendiculaire à la face arrière (14) et raccordée à celle-ci par une surface rentrante (6, 7) agencée pour dégager une portion desdits, fils, caractérisé en ce que ladite surface arrière est conformée de façon que le rabattement dudit corps d'une première position où sa face arrière (14) est en appui sur la carte et joue le rôle d'entretoise définissant une distance prédéterminée entre la surface arrière du voyant et la surface du circuit imprimé en vue de la soudure des fils non cambrés introduits dans les trous de raccordement, à une seconde position où ladite surface de référence (9) est en appui sur la carte, ait pour effet de provoquer un cambrage prédéterminé desdits fils.

2. Support de voyant lumineux selon la revendication 1, caractérisé en ce que lesdits moyens de fixation comprennent un crochet (8) agencé pour coopérer, par encliquetage, avec le bord du circuit imprimé (CI) voisin des trous de passage des fils, lorsque ledit corps est en position rabattue.

3. Support de voyant lumineux selon la revendication 2, caractérisé en ce que ladite surface rentrante (6, 7) est conformée pour servir de gabarit de cambrage auxdits fils, de telle sorte qu'après encliquetage, une contrainte élastique continue d'être exercée sur lesdits fils. 4. Support de voyant lumineux selon la revendication 3, caractérisé en ce que ladite surface rentrante a une forme, de gradin de hauteur (6) dont la largeur (7) est parallèle à ladite face arrière (14).

5. Support de voyant lumineux selon la revendication 2, caractérisé en ce que ledit crochet (8) est solidaire de ladite surface de référence (9) et comporte un chanfrein (81) à son extrémité d'encliquetage.

6. Support de voyant lumineux selon l'une des revendications 1 à 5, caractérisé en ce que lesdites mâchoires (1, 2) constituent un logement pour un corps cylindrique ou en forme d'ogive du voyant, agencé pour que l'axe de symétrie de celui-ci soit maintenu dans une direction sensiblement parallèle à ladite dimension longitudinale.

7. Support de voyant lumineux selon la revendication 6, caractérisé en ce que les surfaces internes desdites mâchoires (1, 2), qui délimitent ledit logement, forment des chanfreins (11, 21) limités vers l'arrière par des arêtes (12, 22) agencées pour freiner l'extraction du corps du voyant.

8. Support de voyant lumineux selon la revendication 4, caractérisé en ce que lesdits trous de passage des fils (4, 5) s'ouvrent vers l'arrière dudit corps au niveau de ladite surface d'appui et sont prolongés, vers l'arrière, par des rainures débouchant au niveau de la largeur (7) dudit gradin.

9. Ensemble de support comprenant une pluralité de supports de voyants lumineux conformes à l'une des revendications 1 à 8, identiques et dont les corps sont rattachés entre eux par des parties affaiblies (16) permettant la séparation de la pluralité des supports.

10. Ensemble selon la revendication 9, caractérisé en ce que lesdites parties affaiblies sont munies de trous (17) destinés à l'introduction d'outils de centrage de l'ensemble par rapport à un circuit imprimé.

**Patentansprüche**

1. Leuchtanzeigehalterung mit einem, länglichen Isolierkörper, dessen Vorder- und Rückseite im wesentlichen senkrecht zu dessen Längserstreckung verlaufen und der auf der Vorderseite Backen besitzt, zur Einführung der Leuchtanzeige, einer Stützfläche im Inneren des besagten Körpers, die mit der Rückseite der Leuchtanzeige zusammenarbeitet, im besagten Körper angebrachten Durchgangslöchern für die Drähte der Leuchtanzeige und Befestigungsmitteln an einer gedruckten Schaltkarte, die mit Löchern für den Anschluss der Drähte versehen ist, wobei besagter Körper eine Referenzfläche (9) bildet, die senkrecht zur Rückseite (14) verläuft und an diese mittels einer einspringenden Fläche (6, 7) angeschlossen ist, um einen Abschnitt der besagten Drähte freizulassen, dadudch gekennzeichnet, dass die besagte Rückseite so ausgebildet ist, dass die Hedabschwenkung des besagten Körpers aus einer ersten Stellung, in der seine Rückseite (14) auf ded Karte aufliegt und die Rolle eines Steges spielt, welcher einen vorbestimmten Abstand zwischen der Rückseite der Leuchtanzeige und der Oberfläche der gedruckten Schaltung hält, um die nicht gebogenen, in die Anschlusslöcher eingeführten, Drähte zu verschweissen, in eine zweite Stellung, in der die besagte Referenzfläche (9) auf der Karte aufliegt eine vorbestimmte Krümmung der besagten Drähte zur Folge hat.

2. Leuchtanzeigehalterung nach Anspruch 1, dadurch gekennzeichnet, dass zu besagten Befestigungsmitteln ein Haken (8) gehört der so angelegt ist, dass er durch Einschnappen mit demjenigen Rand der gedruckten Schaltung (Cl) zusammenarbeitet, der den Durchgangslöchern für die Drähte benachbart ist, wenn besagter Körper sich in der herabgeschwenkten Stellung befindet.

3. Leuchtanzeigehalterung nach Anspruch 2, dadurch gekennzeichnet, dass besagte einspringende Fläche (6, 7) so ausgebildet ist, dass sie als Krümmungsschablone für besagte Drähte dient, sodass, nach dem Einschnappen, auf besagte Dräht, weiterhin eine beständige elastische Beanspruchung ausgeübt wird.

4. Leuchtanzeigehalterung nach Anspruch 3, dadurch gekennzeichnet, dass besagte einspringend Fläche die Form einer senkrechten Stufe (6) hat, deren Breite (7) parallel zu besagted hinterer Fläche (14) ist.

5. Leuchtanzeigehalterung nach Anspruch 2, dadurch gekennzeichnet, dass besagter Haken (8) fest mit der besagten Referenzfläche (9) verbunden ist und an seinem Eindastende eine Abschrägung (81) besitzt.

6. Leuchtanzeigehalterung nach einem der Ansprüche 1 bis 5, dadudch gekennzeichnet, dass besagte Klemmbacken (1, 2) eine Behausung für den zylindrischen oder spitzkeilförmigen Körper der Leuchtanzeige bilden, die so angelegt ist, dass ihre Symmetrieachse in einer im wesentlichen zur besagten Längserstreckung parallelen Richtung gehalten wird.

7. Leuchtanzeigehalterung nach Anspruch 6, dadurch gekennzeichnet, dass die Innenflächen der besagten Klemmbacken (1, 2), welche die besagte Behausung begrenzen, Schrägflächen bilden (11, 21), die nach rückwärts von Kanten (12, 22) begrenzt werden, die so angelegt sind, dass sie das Herausnehmen des Leuchtanzeigekörpers erschweren.

8. Leuchtanzeigehalterung nach Anspruch 4, dadurch gekennzeichnet, dass besagte Durchgangslöcher (4, 5) für die Drähte gegen die Rückseite des besagten Körpers in Höhe der besagten Auflagefläche hin offen sind und nach hinten durch Rillen verlängert werden, die in die Stufenbreitfläche (7) münden.

9. Halterungseinhait mit einer Vielzahl von identischen Leuchtanzeigehalterungen nach einem der Ansprüche 1 bis 8, deren Körper durch schwächere Abschnitte (16) miteinander verbunden sind, welche es ermöglichen, die Vielzahl der Halterungen voneinander zu trennen.

10. Einheit nach Anspruch 9, dadurch gekennzeichnet, dass besagte schwächere Abschnitte mit Löchern (17) versehen sind, zur Einführung von Werkzeugen zur Zentrierung der Einheit im Verhältnis zu einer gedruckten Schaltung.

**Claims**

1. A visual indicator lamp support comprising an elongate insulating body having a front face and a rear face substantially perpendicular to its longitudinal dimension and forming, at its front face, jaws for insertion of the indicator lamp, a bearing surface inside said body cooperating with the rear surface of the indicator lamp, passage holes for the wires thereof formed through said body and means for securing to a printed circuit card, having holes for connecting the wires, said body forming a reference surface (9) perpendicular to the rear face (14) and joined thereto by a re-entrant surface (6, 7) adapted so as to free a portion of said wires, characterized in that said rear surface is shaped so that bending said body back from a first position, in which its rear face (14) is in abutment against the card and plays the role of spacer defining a predetermined distance between the rear face of the indicator lamp and the surface of the printed circuit for soldering the non-bent wires inserted into the connexion holes to a second position in which said reference surface (9) is in abutment against the card, results in causing predetermined bending of said wires.

2. The visual indicator lamp support as claimed in claim 1, characterized in that said securing means comprise a hook (8) adapted for cooperating by clipping-on, with the edge of the printed circuit (CI) adjacent the passage holes for the wires, when said body is in a bent-back position.

3. The visual indicator lamp support as claimed in claim 2, characterized in that said re-entrant surface (6, 7) is shaped so as to serve as a bending jig for said wires so that after clipping-on a resilient stress continues to be exerted on said wires.

4. The visual indicator lamp support as claimed in claim 3, characterized in that said re-entrant surface has the form of a step in height (6) whose width (7) is parallel to said rear face (14).

5. The visual indicator lamp support as claimed in claim 2, characterized in that said hook (8) is integral with said reference surface (9) and comprises a chamfer (81) at its clip-on end.

6. The visual indicator lamp support as claimed in one of claims 1 to 5, characterized in that said jaws (1, 2) form a housing for a cylindrical or ogival shaped body of said indicator lamp adapted so that the axis of symmetry thereof is held in a direction substantially parallel to said longitudinal dimension.

7. The visual indicator lamp support as claimed in claim 6, characterized in that the internal surfaces of said jaws (1, 2) which define said housing, form chamfers (11, 21) limited rearwardly by edges (12, 22) adapted for braking removal of the body of the indicator lamp.

8. A visual indicator lamp support as claimed in claim 4 characterized in that said holes for passing the wires (4, 5) through open rearwardly of said body at the level of said bearing surface and are extended rearwardly by grooves opening at the level of the width (7) of said step.

9. A support assembly comprising a plurality of visual indicator lamp supports such as claimed in one of claims 1 to 8 which are identical and whose bodies are joined together by weakened portions (16) allowing separation of the plurality of supports.

10. The assembly as claimed in claim 9, characterized in that weakened portions are provided with holes (17) for introducing therein tools for centering the assembly with respect to a printed circuit.

FIG.1

FIG.2

0 133 396

FIG. 3

FIG. 4

0 133 396

# FIG.5

16  16  16  16  16

17

18

0 133 396